# FASCICULE DE BREVET EUROPEEN

(11) **EP 2 833 461 B1**
(45) Date de publication et mention de la délivrance du brevet: **13.09.2017**
(21) Numéro de dépôt: 14178955.2
(22) Date de dépôt: 29.07.2014
(51) Int. Cl.: H01M 10/052, H01M 10/0562, H01M 10/0585, H01M 6/18, H01M 6/40, H01M 4/1395

(54) **Procédé de fabrication d'une microbatterie au lithium**
Herstellungsverfahren einer Lithium-Mikrobatterie
Method of manufacturing a lithium microbattery

(30) Priorité: 29.07.2013 FR 1301817
(43) Date de publication de la demande: 04.02.2015
(73) Titulaire: Commissariat à l'Energie Atomique et aux Energies Alternatives, 75015 Paris (FR)
(72) Inventeur: Oukassi, Sami, 38120 Saint-Egrève (FR); Bazin, Arnaud, 38600 FONTAINE (FR)
(74) Mandataire: Talbot, Alexandre

(56) Documents cités:
- FR-A1- 2 862 437
- FR-A1- 2 873 854
- FR-A1- 2 943 181

## Description

### Domaine technique de l'invention

L'invention est relative à la structuration d'une couche d'électrolyte solide pour, notamment réaliser une microbatterie au lithium.

### État de la technique

Une microbatterie au lithium est un accumulateur électrochimique mettant en jeu des ions Li⁺ et comportant un empilement actif de couches minces. L'empilement actif est formé par deux électrodes, une positive et une autre négative, séparées par un électrolyte solide.

L'électrolyte solide est un isolant électrique ayant une forte conductivité ionique. L'électrolyte solide est généralement à base d'un composé lithié. Par ailleurs, l'électrode positive est un matériau d'insertion du lithium, par exemple les oxydes de métaux lithiés.

Les microbatteries au lithium dites « lithium-métal » comportent une électrode négative en lithium métallique. Par ailleurs, les microbatteries au lithium dites « lithium-ion » comportent une électrode négative formée par un matériau d'intercalation ou d'insertion du lithium.

Les microbatteries au lithium sont particulièrement intéressantes grâce à leur forte densité massique, et leur faible toxicité. Cependant, une microbatterie au lithium est très sensible à l'air et à l'humidité.

En effet, les couches à base de lithium sont très réactives et très instables chimiquement. La présence de lithium et, dans certains cas de soufre, dans des couches minces formant une microbatterie, confère à ces couches un caractère fortement hygroscopique et une instabilité chimique à l'air. Ainsi, ce type de couches minces, notamment les couches d'électrolyte solide, sont difficiles à structurer.

De ce fait, une attention particulière doit être portée aux différentes étapes de réalisation et d'encapsulation d'une microbatterie au lithium.

Pour la fabrication d'une microbatterie, une technique classique consiste à déposer successivement les couches minces de la micro-batterie, notamment par des techniques de dépôt sous vide.

La structuration d'une couche d'électrolyte solide est généralement réalisée en utilisant un masquage mécanique (« shadow masking » selon la terminologie anglosaxonne). Le dépôt sous vide, PVD par exemple (« Physical Vapor Déposition »), peut être réalisé à travers un masque mécanique présentant des évidements. Le masque est posé sur le substrat et maintenu en position pendant la durée du dépôt. Ensuite, le masque mécanique est retiré et le substrat présente les motifs souhaités.

Cette technique de masquage génère une contamination particulaire, et le masque mécanique peut également rayer la couche sur laquelle il est posé, risquant ainsi d'endommager fortement la microbatterie. Par ailleurs, lorsque la taille de la microbatterie est réduite, le masque mécanique peut générer des effets de bords ou d'ombrage qui s'avèrent néfastes pour un bon fonctionnement de la microbatterie.

En outre, la demande internationale WO2012173874 divulgue un procédé de réalisation de microbatteries au lithium en utilisant une technique de structuration d'une couche d'électrolyte en oxynitrure phosphoré de lithium (LiPON) par ablation laser. Les couches minces formant les électrodes, et les collecteurs de courant sont formées d'une manière classique en utilisant un dépôt à travers un masque mécanique. Par ailleurs, l'électrolyte solide est déposé sans l'utilisation d'un masque mécanique, et sa structuration est réalisée en utilisant un faisceau laser pulsé ayant une taille de 1 mm². Le faisceau laser doit balayer toute la surface utile du substrat sur lequel les microbatteries sont réalisées.

Par ailleurs, cette technique dépend fortement du substrat utilisé ainsi que de la nature des couches déposées à des niveaux inférieurs. En outre, ce procédé peut nécessiter l'utilisation de dispositifs différents, ce qui augmente le risque d'exposition de la couche d'électrolyte solide à l'air et l'humidité. Ainsi, la mise en oeuvre de ce procédé de réalisation est lente et complexe.

La demande FR2943181 décrit un procédé de réalisation d'une microbatterie au lithium comprenant la formation d'un empilement substrat 11, première électrode 14, électrolyte solide 15, seconde électrode 16/collecteur 17, la gravure de la seconde électrode/collecteur de courant et la gravure sélective de l'électrolyte et de la première électrode. L'étape de gravure de la seconde électrode/collecteur peut se faire au travers d'un masque photolithographique 22 qui est ensuite éliminé par des techniques connues, dont la gravure.

### Objet de l'invention

L'invention a pour objet un procédé de réalisation d'une microbatterie au lithium facile à réaliser, peu couteux et compatible avec les technologies mises en oeuvre dans le domaine de la microélectronique.

On tend vers cet objet en prévoyant un procédé de réalisation d'une microbatterie au lithium, comportant les étapes successives suivantes :
- prévoir un empilement de couches comportant successivement :
   - une première couche en premier matériau ;
   - une deuxième couche en deuxième matériau configuré pour s'allier avec les atomes de lithium ;
   - une couche d'électrolyte solide ;
   - une première électrode ;
- graver les premier et deuxième matériaux pour former un premier motif en premier matériau et un deuxième motif en deuxième matériau, le deuxième motif définissant une zone couverte et une zone découverte de la couche d'électrolyte ;
- graver la zone découverte de la couche d'électrolyte, en utilisant le deuxième motif comme masque de gravure, et éliminer le premier motif ;
- former sur le deuxième motif une couche à base de lithium, le deuxième matériau étant configuré de sorte que les atomes de lithium diffusent dans le deuxième motif, la couche à base de lithium et le deuxième motif formant une deuxième électrode à base de lithium.

De manière avantageuse la formation des premier et deuxième motifs comporte les étapes suivantes :
- graver le premier matériau de manière à définir le premier motif en premier matériau disposé sur la deuxième couche ;
- graver le deuxième matériau pour former le deuxième motif en utilisant le premier motif comme masque de gravure.

En outre, la gravure de la zone découverte de la couche d'électrolyte et la gravure du premier motif sont, avantageusement, réalisées simultanément.

Avantageusement, la gravure du deuxième matériau est réalisée par une gravure plasma en se servant de la couche d'électrolyte comme une couche d'arrêt de la gravure.

Par ailleurs, selon d'autres caractéristiques avantageuses et non limitatives :
- la couche à base de lithium et le premier matériau du premier motif subissent un traitement thermique configuré pour faire diffuser les atomes de lithium dans le deuxième motif ;
- la deuxième électrode comporte une concentration en atome de lithium d'au moins 90% ;
- la couche d'électrolyte est à base d'un matériau choisi parmi LiPON, LiSiPON, Thio-LiSiCON ou LiBON ;
- la deuxième couche est à base d'un matériau choisi parmi Si, Ge, Sn, C, Au ou Pt ;
- la première couche est à base d'un matériau choisi parmi Al, Al₂O₃, Ti, Ni, Cr, ou LiPON ;
- le premier motif est conformé par dépôt d'une couche en résine photosensible sur la première couche suivie d'une étape de photolithographie et d'une étape de gravure du premier matériau.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- les figures 1 à 5 représentent, de manière schématique, en vue de coupe, des étapes de réalisation d'une microbatterie selon un mode de réalisation ;
- la figure 6 représente, de manière schématique, en vue de coupe, une variante d'une étape de réalisation d'une microbatterie selon un mode de réalisation ;
- la figure 7 représente, de manière schématique, en vue de coupe, une variante d'une autre étape de réalisation d'une microbatterie selon un mode de réalisation.

### Description de modes de réalisation préférentiels de l'invention

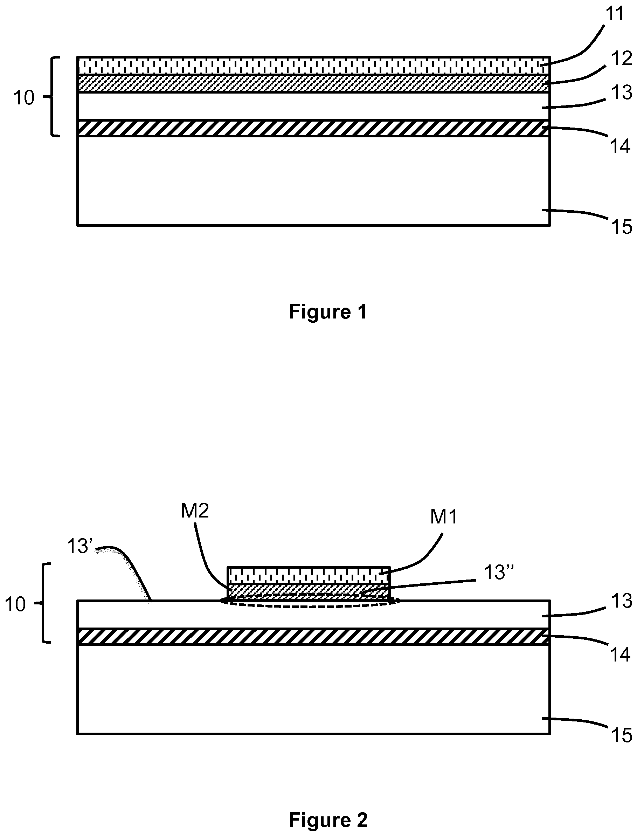

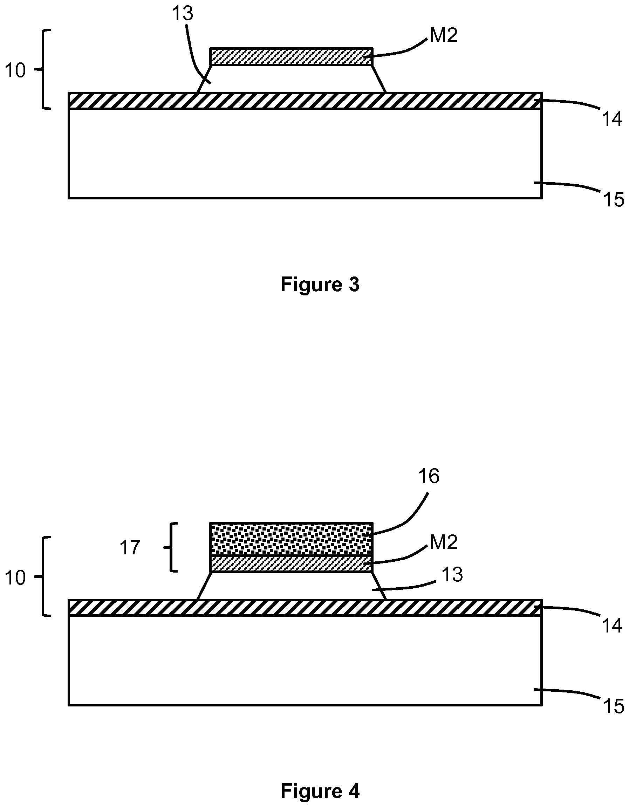

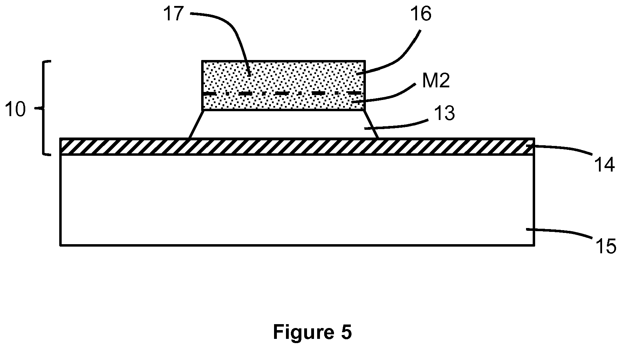

Selon un premier mode de réalisation illustré aux figures 1 à 5, le procédé comporte la fourniture d'un empilement 10 comportant successivement une première couche 11 en premier matériau, une deuxième couche 12 en deuxième matériau, une couche d'électrolyte solide 13 et une première électrode 14. En particulier, les couches minces 12 à 14 sont destinées à former une microbatterie au lithium.

Les couches minces 11 à 14 peuvent être déposées successivement sur un substrat 15 par des techniques classiques de l'industrie microélectronique, par exemple par dépôt physique en phase vapeur (« Physical Vapor Deposition », PVD), dépôt par évaporation sous vide, dépôt chimique en phase vapeur (« Chemical Vapor Deposition », CVD). L'épaisseur des couches minces 11 à 14 peut varier entre quelques nanomètres et quelques dizaines de micromètres.

Le substrat 15 est généralement une plaque de silicium, pouvant comporter un circuit intégré. Le substrat peut également être en verre ou en céramique. Le substrat 15 peut être recouvert, par une couche de passivation, typiquement à base d'oxyde de silicium, ou par une bicouche formée par une couche d'oxyde et une couche de nitrure de silicium. Le substrat 15 peut également former la première électrode 14.

Par ailleurs, la première électrode 14 est généralement une électrode génératrice d'ion Li⁺ ou comportant un matériau d'intercalation du lithium. Le matériau utilisé comme matériau actif de la première électrode 14 peut être un matériau non lithié comme un oxyde de vanadium (VₓO_{y}) ou un oxysulfure de titane (TiOₓS_{y}). Le matériau de l'électrode 14 peut également être un matériau lithié comme un oxyde de lithium et de cobalt (LiCoO₂), ou un oxyde de lithium et de nickel (LiNiO₂), etc.

Le substrat 15 peut également comporter d'autres couches minces, notamment des couches formant des collecteurs de courant de la microbatterie. Classiquement, ces collecteurs de courant sont formés par des couches métalliques, par exemple en platine, chrome, or, titane, etc. L'étape de réalisation de ces collecteurs de courant est indépendante de l'étape de formation de l'empilement 10. Autrement dit, les collecteurs de courant de la microbatterie peuvent être réalisés avant, pendant, ou après l'étape de formation de l'empilement 10.

Comme illustré à la figure 1, la couche d'électrolyte solide 13 est disposée sur la première électrode 14. L'électrolyte solide 13 est une couche perméable aux ions lithium, et il est préférentiellement à base de lithium. Autrement dit, l'électrolyte 13 est configuré de manière à permettre la conduction des ions lithium Li⁺. Préférentiellement, le matériau de l'électrolyte solide 13 est un matériau électriquement isolant. L'électrolyte solide 13 peut être en oxynitrure de bore et de lithium (LiBON), en oxynitrure de silicophosphate et de lithium (LiSiPON), etc. De manière préférentielle, l'électrolyte solide 13 est en oxynitrure de phosphore et de lithium (LiPON) dit « lipon ».

L'empilement 10 comporte également une bicouche disposée sur l'électrolyte solide 13. La bicouche est formée par une première couche 11 en premier matériau disposée sur une deuxième couche 12 en deuxième matériau. La bicouche est destinée à former un masque de gravure pour, notamment, structurer la couche d'électrolyte solide 13.

La première couche 11 est une couche sacrificielle, et elle peut être à base d'aluminium (Al), d'alumine (Al₂O₃), titane (Ti), nickel (Ni), chrome (Cr), etc.

La deuxième couche 12 est préférentiellement à base d'un matériau configuré pour s'allier avec les atomes de lithium, ou au moins pour avoir une diffusion des atomes de lithium dans la deuxième couche 12. Le deuxième matériau peut être à base de silicium (Si), germanium (Ge), étain (Sn), carbone (C), or (Au), platine (Pt), etc. La deuxième couche 12 est configurée pour former une deuxième électrode 16, de polarité opposée par rapport à la première électrode 14.

L'épaisseur des couches 11 et 12 est comprise entre quelques nanomètres et quelques dizaines de nanomètres, préférentiellement, entre 5 et 100 nm.

Le procédé de réalisation d'une microbatterie au lithium comporte également une étape de gravure des premier et deuxième matériaux pour former, comme illustré à la figure 2, des premier et deuxième motifs M1 et M2.

Le premier motif M1 est en premier matériau. Le deuxième motif M2 est en deuxième matériau, et il est configuré pour définir une zone couverte 13" et une zone découverte 13' de la couche d'électrolyte solide 13. La deuxième couche 12, notamment le deuxième motif M2, permet de manière avantageuse de protéger la couche d'électrolyte 13 et surtout l'interface entre l'électrolyte solide 13 et le deuxième matériau lors des différentes étapes de réalisation de la microbatterie.

La gravure des premier et deuxième matériaux est réalisée par tout moyen connu, par exemple, par des techniques classiques dans le domaine de la microélectronique et compatible avec les premier et deuxième matériaux.

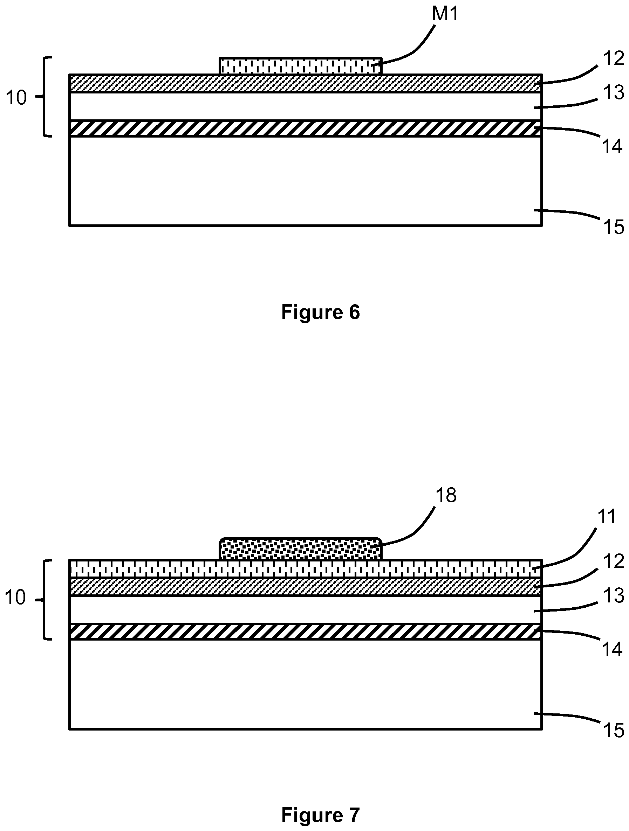

De manière avantageuse, la formation des premier et deuxième motifs M1 et M2 est réalisée en gravant dans un premier temps le premier matériau de manière à définir le premier motif M1 en premier matériau disposé sur la deuxième couche 13. Comme illustré à la figure 6, le premier motif M1 est formé alors que l'électrolyte solide 13 est protégé par la deuxième couche 12. Le premier motif M1 est ensuite utilisé comme masque de gravure pour former le deuxième motif M2 en gravant le deuxième matériau.

Comme illustré à la figure 7, le premier motif M1 est avantageusement conformé par dépôt d'une couche en résine 18 photosensible sur la première couche 11 suivie d'une étape de photolithographie et d'une étape de gravure. L'utilisation d'une résine photosensible et d'une étape de gravure, est facile à réaliser, compatible avec plusieurs matériaux à graver, et elle permet de définir des motifs avec une très grande précision.

Selon un exemple de réalisation, la première couche 11 est en aluminium et elle a une épaisseur de 20 nm. La deuxième couche 12 est en silicium et elle a une épaisseur de 10 nm. Selon cet exemple de réalisation, le motif M1 est réalisé en déposant une couche de résine photosensible 18, par exemple de type S1818 fabriquée par Shipley. Une étape de photolithographie est ensuite effectuée comme illustré à la figure 7. Autrement dit, la couche de résine 18 est insolée puis développée de manière à définir un motif de protection d'une portion de la première couche 11. Les zones de la première couche 11 en aluminium qui ne sont pas protégées par le motif de protection en résine 18, sont éliminées sélectivement par rapport au deuxième matériau 12, en l'occurrence le silicium. Cette élimination peut être réalisée par une gravure humide en solution commerciale « AL ETCH » comportant un mélange d'acide phosphorique, d'acide nitrique et d'acide acétique à température ambiante. Après la gravure de la couche 11, la résine est retirée à l'aide d'un jet d'acétone.

Par ailleurs, le deuxième matériau est avantageusement gravé par plasma pour former le deuxième motif M2. Le deuxième matériau est gravé en se servant avantageusement de la couche d'électrolyte solide 13 comme une couche d'arrêt de la gravure.

Selon l'exemple de réalisation, la gravure de la deuxième couche 12 en silicium est effectuée par gravure ionique réactive avec un plasma ICP (ICP pour « Inductively Coupled Plasma ») comportant des gaz de SF₆ et d'argon. La gravure a été réalisée dans un réacteur RIE (« Reactive Ion Etching ») sous les conditions suivantes : pression de 5 mTorr, puissance source de 200 W, tension d'auto-polarisation de 100 V, température de 20 °C, débit de SF₆ de 20 sccm et débit d'argon de 10 sccm pendant 100 s. L'arrêt de gravure est réalisé, par exemple en détectant la couche d'électrolyte par luminescence du plasma.

L'utilisation d'une gravure plasma de la deuxième couche, permet de manière avantageuse d'éviter que la couche d'électrolyte solide soit en contact avec une solution aqueuse. Ainsi, on évite ou du moins on minimise la détérioration de l'électrolyte solide. Bien qu'une gravure plasma puisse engendrer une légère détérioration de la zone découverte 13' de la couche d'électrolyte, notamment d'un point de vue rugosité, cette zone 13' sera par la suite éliminée. Ainsi, une dégradation de la rugosité de cette zone 13' n'est pas rédhibitoire pour la réalisation d'une microbatterie au lithium opérationnelle. D'autant plus que l'interface entre l'électrolyte 13 et la deuxième couche 12 reste avantageusement protégée et n'est pas impactée par le bombardement plasma.

Après la formation du deuxième motif M2, ce dernier est utilisé comme masque de gravure pour graver la zone découverte 13' de la couche d'électrolyte 13. En outre, le premier motif M1 est également gravé.

De manière avantageuse, le premier motif M1 et la zone découverte 13' sont gravés simultanément. De manière encore plus avantageuse, les matériaux de la première couche 11 et de l'électrolyte 13 sont choisis pour être gravés par une même technique, simultanément.

Selon l'exemple de réalisation, la première couche 11 est en aluminium et la couche d'électrolyte est en lipon, et la gravure des deux matériaux peut avantageusement être réalisée en utilisant une même solution aqueuse, par exemple, à base de H₃PO₄.

Par ailleurs, l'épaisseur de la première couche 11 est fixée de sorte à être inférieure à une épaisseur maximum qui dépend de la vitesse de gravure du premier matériau par la solution de gravure ainsi que le temps nécessaire pour graver la zone découverte 13' de la couche d'électrolyte 13. Ladite épaisseur maximum est sensiblement égale au temps nécessaire pour graver la zone découverte 13', multiplié par la vitesse de gravure du premier matériau. Autrement dit, l'épaisseur de la première couche est choisie de sorte que le temps de gravure de cette dernière soit inférieur au temps de gravure de la zone découverte 13' de la couche d'électrolyte.

Selon l'exemple de réalisation, la couche d'électrolyte 13 a une épaisseur d'environ 1,5 µm. Une solution acide à base de H₃PO₄ obtenue en mélangeant 2 volumes d'eau et 1 volumes de H₃PO₄ peut être utilisée pour graver simultanément le lipon et l'aluminium du premier motif M1. De ce fait, la première couche 11 en aluminium, est configurée pour avoir une épaisseur inférieure à 20 nm.

En outre, le procédé de réalisation de la microbatterie comporte une étape de formation d'une couche à base de lithium 16 sur le deuxième motif M2, après la gravure de la zone découverte 13' et du premier motif M1. Le deuxième matériau est configuré de sorte que les atomes de lithium diffusent dans le deuxième motif M2, la couche à base de lithium 16 et le deuxième motif M2 formant ainsi une deuxième électrode 17 à base de lithium.

Préférentiellement, la couche 16 est une couche en lithium. La couche 16 peut être également à base d'un alliage de lithium. Par ailleurs, la couche à base de lithium 16 peut être réalisée par tout moyen connu et compatible avec les matériaux des différentes couches de la microbatterie, notamment la deuxième couche 12. Par exemple, la couche 16 peut être réalisée par évaporation thermique, par pulvérisation, ou encore par électrodépôt.

Préférentiellement, la couche 16 à base de lithium est déposée de manière localisée sur le deuxième motif M2. Par dépôt localisé, on entend un dépôt uniquement sur le deuxième motif M2. De ce fait, on s'affranchit avantageusement d'utiliser une étape de structuration, notamment, une gravure pour obtenir un motif structuré formant l'électrode 17. En effet, vu qu'une couche riche en lithium présente une très forte instabilité chimique, il est techniquement très difficile, voire impossible, de graver une telle couche riche en lithium afin d'obtenir un motif structuré, tel que décrit ci-dessus.

La couche à base de lithium 16 est avantageusement configurée pour réagir avec le deuxième matériau du motif M2, de sorte à former la deuxième électrode 17 en un alliage riche en lithium. Par un alliage riche en lithium, on entend un alliage comportant au moins 90 % d'atomes de lithium.

Ainsi, le procédé de fabrication selon l'invention permet de manière avantageuse d'éviter une étape de gravure de la couche 16 riche en lithium et d'éviter toute dégradation de cette couche en réalisant toutes les structurations avant le dépôt de la couche 16.

La technique de dépôt de la couche à base de lithium 16 sur le deuxième motif M2 est configurée de manière à faire diffuser les atomes de lithium dans le deuxième matériau du deuxième motif. Par exemple, la technique de dépôt peut générer une élévation de la température permettant la diffusion des atomes de lithium dans le deuxième motif M2 de manière à former un alliage riche en lithium. On peut réaliser, notamment, un traitement thermique au substrat lors du dépôt de la couche 16 en contrôlant la température du porte substrat. D'une manière générale, ce sont les mécanismes de diffusion qui régissent la formation d'un alliage lithium-deuxième matériau.

De manière avantageuse, on applique un traitement thermique lors et/ou après le dépôt de la couche à base de lithium 16 pour accélérer et favoriser la réaction du matériau de la couche 16 avec le deuxième matériau du motif M2. Autrement dit, la couche 16 et le motif M1 subissent un traitement thermique configuré pour faire diffuser les atomes de lithium de la couche 16 dans le premier motif M1.

En outre, l'épaisseur de la deuxième couche 12 est faible par rapport à l'épaisseur de la couche à base de lithium 16. En effet, l'épaisseur de la couche 12 est choisie de manière à permettre la formation d'un alliage lithium-deuxième matériau, riche en lithium.

Selon l'exemple de réalisation, la deuxième couche 12 est en silicium, et possède une épaisseur comprise entre 50 et 100 nm. Suivant ces conditions, la couche 16 est en lithium et son épaisseur est choisie supérieure à 1 µm.

Le procédé décrit ci-dessus permet de structurer une couche d'électrolyte solide pour former une microbatterie.

Par ailleurs, la présence de lithium confère à ce type de couche un caractère hygroscopique et une instabilité à l'air, ce qui rend sa structuration difficilement réalisable.

Lors de la structuration de ce type de couche, il est avantageux d'éviter ou du moins minimiser les étapes dans lesquelles la couche est en contact avec une résine photosensible ou avec des solutions aqueuses, par exemple de développement ou de retrait. En effet, le contact d'un électrolyte solide, par exemple en lipon, avec ce type de produits peut modifier la composition chimique de l'électrolyte par oxydation et/ou hydratation du lithium, il peut également modifier la morphologie de la couche d'électrolyte causée par une expansion volumique et/ou une décohésion.

Dans une microbatterie au lithium, le transfert d'ions de lithium (Li⁺) s'effectue au niveau de l'interface entre l'électrolyte et l'électrode négative. Ainsi, la qualité de cette interface est très critique. Une réactivité chimique à cette interface, qui peut survenir lors de la structuration de la couche d'électrolyte, peut causer la formation d'une phase oxyde ou autre entre l'électrolyte et la couche d'électrode négative disposée au-dessus. Cette phase interposée entre ces deux couches actives de la microbatterie, peut empêcher sinon ralentir la diffusion des ions de lithium, engendrant de ce fait une forte résistance de transfert de charges au sein de la microbatterie et une détérioration des propriétés électrochimiques attendues.

Le procédé de réalisation d'une microbatterie selon l'invention comporte une disposition de première et deuxième couches sur l'électrolyte solide avant sa structuration. La deuxième couche est avantageusement en contact avec la couche d'électrolyte solide et la protège. La deuxième couche est également destinée pour former l'électrode négative à base de lithium. Ainsi, cette disposition astucieuse permet de manière avantageuse de structurer la couche d'électrolyte solide tout en préservant l'interface électrolyte/électrode négative tout le long du procédé de réalisation de la microbatterie.

Avantageusement, la deuxième couche disposée sur l'électrolyte solide évite tout contact de l'électrolyte solide, notamment l'interface électrolyte/électrode négative, avec une résine photosensible. Par ailleurs, le procédé de réalisation minimise le contact de la couche d'électrolyte avec des solutions aqueuses.

En outre, la première couche disposée sur la deuxième couche, permet de préserver également l'interface de la deuxième couche sur laquelle une couche à base de lithium est déposée pour former ladite électrode négative de la microbatterie.

De plus, le procédé de fabrication selon l'invention évite l'utilisation des masques mécaniques ce qui permet, de manière avantageuse, d'éviter les effets d'ombrage et une contamination particulaire. De ce fait, le procédé permet d'augmenter la densité d'intégration de microbatteries au lithium réalisées sur un même substrat, et d'obtenir des motifs ayant un alignement précis tout en préservant la qualité de l'électrolyte solide. En effet, le dépôt d'une couche d'électrolyte à travers un masque mécanique ne permet pas de réaliser des motifs de tailles micrométriques ou nanométriques comme les techniques classiques de lithogravure utilisés dans le domaine de la microélectronique. Par ailleurs, le dépôt à travers un masque génère en outre des effets d'ombrage, impactant négativement la compacité des microbatteries réalisées ainsi que leurs propriétés électrochimiques.

Par ailleurs, le procédé décrit ci-dessus permet une structuration de plusieurs motifs de l'électrolyte solide simultanément, ce qui diminue le temps de réalisation du procédé de fabrication des microbatteries au lithium, contrairement à une technique de structuration de l'électrolyte solide par ablation laser.

L'utilisation des première et deuxième couches comme masques de gravure, permet de faciliter la réalisation de la microbatterie tout en utilisant des techniques classiques du domaine de la microélectronique. Ainsi, il est plus facile d'incorporer ou d'intégrer une microbatterie au lithium sur un microcomposant ou sur un substrat comportant d'autres dispositifs microélectroniques ou microsystèmes.

## Revendications

1. Procédé de réalisation d'une microbatterie au lithium, comportant les étapes successives suivantes :
• prévoir un empilement de couches (10) comportant successivement :
- une première couche (11) en premier matériau ;
- une deuxième couche (12) en deuxième matériau configuré pour s'allier avec les atomes de lithium ;
- une couche d'électrolyte solide (13) ;
- une première électrode (14) ;
• graver les premier et deuxième matériaux pour former un premier motif (M1) en premier matériau et un deuxième motif (M2) en deuxième matériau, le deuxième motif définissant une zone découverte (13') et une zone couverte (13") de la couche d'électrolyte (13) ;
• graver la zone découverte (13') de la couche d'électrolyte (13), en utilisant le deuxième motif (M2) comme masque de gravure, et graver le premier motif (M1) ;
• déposer de manière localisée sur le deuxième motif (M2) une couche à base de lithium (16), le deuxième matériau étant configuré de sorte que les atomes de lithium diffusent dans le deuxième motif (M2), la couche à base de lithium (16) et le deuxième motif (M2) formant une deuxième électrode (17) à base de lithium.

2. Procédé selon la revendication 1, **caractérisé en ce que** la formation des premier et deuxième motifs (M1, M2) comporte les étapes suivantes :
- graver le premier matériau de manière à définir le premier motif (M1) en premier matériau disposé sur la deuxième couche (12) ;
- graver le deuxième matériau pour former le deuxième motif (M2) en utilisant le premier motif (M1) comme masque de gravure.

3. Procédé selon l'une des revendications 1 et 2, **caractérisé en ce que** la gravure de la zone découverte (13') de la couche d'électrolyte (13) et la gravure du premier motif (M1) sont réalisées simultanément.

4. Procédé selon l'une quelconque des revendications 1 à 3, **caractérisé en ce que** la formation du deuxième motif (M2) est réalisée par une gravure plasma du deuxième matériau en se servant de la couche d'électrolyte (13) comme une couche d'arrêt de la gravure.

5. Procédé selon l'une quelconque des revendications 1 à 4, **caractérisé en ce que** la couche à base de lithium (16) et le premier matériau du premier motif (M1) subissent un traitement thermique configuré pour faire diffuser les atomes de lithium dans le premier motif (M1).

6. Procédé selon l'une quelconque des revendication 1 à 5, **caractérisé en ce que** la deuxième électrode (17) comporte une concentration en atome de lithium d'au moins 90%.

7. Procédé selon l'une quelconque des revendications précédentes, **caractérisé en ce que** la couche d'électrolyte (13) est à base d'un matériau choisi parmi LiPON, LiSiPON, Thio-LiSiCON ou LiBON.

8. Procédé selon l'une quelconque des revendications précédentes, **caractérisé en ce que** la deuxième couche (12) est à base d'un matériau choisi parmi Si, Ge, Sn, C, Au ou Pt.

9. Procédé selon l'une quelconque des revendications précédentes, **caractérisé en ce que** la première couche (11) est à base d'un matériau choisi parmi Al, Al₂O₃, Ti, Ni, Cr, ou LiPON.

10. Procédé selon l'une quelconque des revendications précédentes, **caractérisé en ce que** le premier motif (M1) est conformé par dépôt d'une couche en résine (18) photosensible sur la première couche (11) suivie d'une étape de photolithographie et d'une étape de gravure du premier matériau.

## Patentansprüche

1. Verfahren zur Herstellung einer Lithium-Mikrobatterie, das folgende aufeinanderfolgende Verfahrensschritte umfasst:
- Vorsehen einer Schichten-Stapelung (10), die aufeinanderfolgend umfasst:
- eine erste Schicht (11) aus einem ersten Material;
- eine zweite Schicht (12) aus einem zweiten Material, das geeignet ist, sich mit Lithiumatomen zu verbinden;
- eine Feststoff-Elektrolyt-Schicht (13);
- eine erste Elektrode (14);
- Gravieren des ersten und des zweiten Materials, um im ersten Material ein erstes Muster (M1) und im zweiten Material ein zweites Muster (M2) zu formen, wobei das zweite Muster einen unbedeckten Bereich (13') und einen bedeckten Bereich (13") der Elektrolyt-Schicht (13) definiert;
- Gravieren des unbedeckten Bereichs (13') der Elektrolyt-Schicht (13), wobei das zweite Muster (M2) als Gravurmaske verwendet wird, und Gravieren des ersten Musters (M1);
- lokal begrenztes Auftragen einer Schicht auf Lithiumbasis (16) auf dem zweiten Muster (M2), wobei das zweite Material dergestalt ausgelegt ist, dass die Lithiumatome in dem zweiten Muster (M2) diffundieren, wobei die Schicht auf Lithiumbasis (16) und das zweite Muster (M2) eine zweite Elektrode (17) auf Lithiumbasis bilden.

2. Verfahren nach Anspruch 1,
**dadurch gekennzeichnet,**
**dass** die Bildung des ersten und des zweiten Musters (M1, M2) folgende Schritte umfasst:
- Gravieren des ersten Materials dergestalt, dass das erste Muster (M1) aus dem ersten, auf der zweiten Schicht (12) aufgetragenen Material entsteht;
- Gravieren des zweiten Materials, um das zweite Muster (M2) zu formen, wobei das erste Muster (M1) als Gravurmaske verwendet wird.

3. Verfahren nach einem der Ansprüche 1 und 2,
**dadurch gekennzeichnet,**
**dass** die Gravur des unbedeckten Bereichs (13') der Elektrolyt-Schicht (13) und die Gravur des ersten Musters (M1) gleichzeitig ausgeführt werden.

4. Verfahren nach einem der Ansprüche 1 bis 3,
**dadurch gekennzeichnet,**
**dass** die Formung des zweiten Musters (M2) durch eine Plasmagravur des zweiten Materials erfolgt, wobei die Elektrolyt-Schicht (13) als Anschlagschicht für die Gravur verwendet wird.

5. Verfahren nach einem der Ansprüche 1 bis 4,
**dadurch gekennzeichnet,**
**dass** die Schicht auf Lithiumbasis (16) und das erste Material des ersten Musters (M1) einer Wärmebehandlung unterzogen werden, welche geeignet ist, die Lithiumatome in dem ersten Muster (M1) diffundieren zu lassen.

6. Verfahren nach einem der Ansprüche 1 bis 5,
**dadurch gekennzeichnet,**
**dass** die zweite Elektrode (17) eine Konzentration an Lithiumatomen von mindestens 90 % enthält.

7. Verfahren nach einem der vorherigen Ansprüche,
**dadurch gekennzeichnet,**
**dass** die Elektrolyt-Schicht (13) auf Basis eines Werkstoffs besteht, der unter LiPON, LiSiPON, Thio-LiSiCON oder LiBON gewählt ist.

8. Verfahren nach einem der vorherigen Ansprüche,
**dadurch gekennzeichnet,**
**dass** die zweite Schicht (12) auf Basis eines Werkstoffs besteht, der unter Si, Ge, Sn, C, Au oder Pt gewählt ist.

9. Verfahren nach einem der vorherigen Ansprüche,
**dadurch gekennzeichnet,**
**dass** die erste Schicht (11) auf Basis eines Werkstoffs besteht, der unter Al, Al₂O₃, Ti, Ni, Cr oder LiPON gewählt ist.

10. Verfahren nach einem der vorherigen Ansprüche,
**dadurch gekennzeichnet,**
**dass** das erste Muster (M1) durch Auftragen einer lichtempfindlichen Harzschicht (18) auf die erste Schicht (11), gefolgt von einem Fotolithographie-Verfahrensschritt und einem Verfahrensschritt des Gravierens des ersten Materials gebildet wird.

## Claims

1. A fabrication method of a lithium microbattery, comprising the following successive steps:
• providing a stack of layers (10) successively comprising:
- a first layer (11) made from a first material;
- a second layer (12) made from a second material configured to combine with the lithium atoms;
- a solid electrolyte layer (13);
- a first electrode (14);
• etching of the first and second materials to form a first pattern (M1) made from the first material and a second pattern (M2) made from the second material, the second pattern defining an uncovered area (13') and a covered area (13") of the electrolyte layer (13);
• etching of the uncovered area (13') of the electrolyte layer (13) using the second pattern (M2) as etching mask, and etching of the first pattern (M1);
• depositing in localized manner a lithium-based layer (16) on the second pattern (M2), the second material being configured such that the lithium atoms diffuse into the second pattern (M2), the lithium-based layer (16) and the second pattern (M2) forming a lithium-based second electrode (17).

2. The method according to claim 1, **characterized in that** formation of the first and second patterns (M1, M2) comprises the following steps:
- etching of the first material so as to define the first pattern (M1) made from the first material arranged on the second layer (12);
- etching of the second material to form the second pattern (M2) using the first pattern (M1) as etching mask.

3. The method according to any one of claims 1 and 2, **characterized in that** etching of the uncovered area (13') of the electrolyte layer (13) and etching of the first pattern (M1) are performed simultaneously.

4. The method according to any one of claims 1 to 3, **characterized in that** formation of the second pattern (M2) is achieved by plasma etching of the second material using the electrolyte layer (13) as etch stop layer.

5. The method according to any one of claims 1 to 4, **characterized in that** the lithium-based layer (16) and the first material of the first pattern (M1) undergo heat treatment configured to make the lithium atoms diffuse into the first pattern (M1).

6. The method according to any one of claims 1 to 5, **characterized in that** the second electrode (17) comprises a lithium atom concentration of at least 90%.

7. The method according to claim 1, **characterized in that** the electrolyte layer (13) is formed by a material chosen from LiPON, LiSiPON, Thio-LiSiCON or LiBON.

8. The method according to any one of the preceding claims, **characterized in that** the second layer (12) is formed by a material chosen from Si, Ge, Sn, C, Au or Pt.

9. The method according to any one of the preceding claims, **characterized in that** the first layer (11) is formed by a material chosen from Al, Al₂O₃, Ti, Ni, Cr, or LiPON.

10. The method according to any one of the preceding claims, **characterized in that** the first pattern (M1) is formed by deposition of a photoresist layer (18) on the first layer (11) followed by a photolithography step and an etching step of the first material.
